# EUROPEAN PATENT SPECIFICATION

(11) **EP 3 176 590 B1**
(45) Date of publication and mention of the grant of the patent: **05.01.2022**
(21) Application number: 16200963.3
(22) Date of filing: 28.11.2016
(51) Int. Cl.: G01R 1/04, G01R 15/20

(54) **CURRENT SENSOR**
STROMSENSOR
CAPTEUR DE COURANT

(30) Priority: 02.12.2015 JP 2015235774
(43) Date of publication of application: 07.06.2017
(73) Proprietor: Alps Alpine Co., Ltd., Tokyo 145-8501 (JP)
(72) Inventor: TAMURA, Manabu, Tokyo 145-8501 (JP); ABE, Minoru, Tokyo 145-8501 (JP)
(74) Representative: Schmitt-Nilson Schraud Waibel Wohlfrom Patentanwälte Partnerschaft mbB

(56) References cited:
- DE-U1-202012 103 071
- KR-B1- 101 332 843
- US-A1- 2011 019 387
- US-A1- 2011 068 771
- US-B1- 6 472 878

## Description

### CLAIM OF PRIORITY

This application claims benefit of Japanese Patent Application No. 2015-235774 filed on December 2, 2015.

### BACKGROUND OF THE INVENTION

### 1. Field of the Invention

The present invention relates to a current sensor that measures a magnetic field that a current to be measured generates.

### 2. Description of the Related Art

In magnetic sensors for multiphase conductors, a technique of sandwiching a conductor with two magnetic shields for every phase, blocking an external magnetic field including an induction field that an adjacent conductor generates, and enhancing measurement accuracy is known.

In such magnetic sensors for multiphase conductors, in a case where the conductor is sandwiched by the two magnetic shields for every phase, it is difficult to precisely position and fix the magnetic shields with respect to the conductor.

Since the magnetic shields have an influence not only on the blocking of the external magnetic field but also on the magnetic flux of the current to be measured, sensitivity varies and causes measurement error if the positions of the magnetic shields deviate.

In order to solve such a problem, there is a technique of integrally molding a conductor (bus bar) and a magnetic shield with the case, thereby enhancing the positional accuracy of the magnetic shield and the conductor.

[Patent Document 1] Japanese Unexamined Patent Application Publication No. 2015-49184

As described above, in a case where a structure in which the conductor is sandwiched by the two magnetic shields is adopted, the magnetic sensor or the like cannot be integrally molded. Therefore, after the magnetic shields are molded integrally with one case, and the magnetic sensor is housed within the case, the lid that closes an opening of the housing space is fixed. The magnetic shields are molded integrally with the lid.

However, the lid and the case cannot be positioned with high accuracy. As a result, there is a problem that the magnetic shields, the conductor, and the magnetic sensor cannot be positioned with high accuracy, and the measurement error readily worsens

KR 101 332 843 B1 shows a method of manufacturing a current sensor for a vehicle comprising a step of inserting connector terminals, molding a sensor body, having a space with an open front part, forming a fitting hole passing through a rear part, including a partition wall protruding from the fitting hole to the space and a guide part arranged around the partition wall, and molding the sensor body in the shape that the connector terminals are separated from the partition wall and arranged in the space.

DE 20 2012 103071 U1 shows a measuring device for at least one contactless current measurement at an electric conductor flowed through by current, wherein one magnetic field sensor sensitive to magnetic field is arranged as current measuring sensor with a corresponding electronic evaluating device in a housing, which comprises a first housing part and a second housing part connected therewith by way of at least one pivot joint.

US 2011/068771 A1 shows a current sensor for outputting a detection signal corresponding to a current flowing through a bus bar. The current sensor includes a magnetic core that concentrates and amplifies a magnetic field generated by the current near a detection portion of the bus bar. A magnetic detection element detects the magnetic field concentrated by the magnetic core and outputs an electrical signal corresponding to the detected magnetic field. The detection portion of the bus bar and the magnetic core are molded integrally with each other.

US 2011/019387 A1 shows a highly accurate current sensing transformer, such as an external neutral current transformer (ENCT), accommodating a wide range of loads. The ENCT includes a housing, first and second terminals each having an end portion extending from and external to the housing, a conductor for carrying a current to be measured, and a current sensor having an aperture for receiving the conductor and having a central axis. The conductor joins the first and second terminals to form a current path that passes through the aperture.

US 6 472 878 B1 shows a current measuring element comprising a current carrying conductor having the shape of a flat rail in an insulating housing and a hall sensor which is arranged in the proximity of said conductor. An insulating cover provided for the housing is arranged between the housing containing the current carrying conductor and a main board.

### SUMMARY OF THE INVENTION

The present invention provides a current sensor that can perform positioning between a conductor, a magnetic sensor, and a magnetic shield with high accuracy and can measure a current to be measured with high accuracy.

A current sensor according to the invention is described in claim 1.

According to this configuration, the lid and the case are positioned with high accuracy with a simple configuration by the engagement between the second opening of the lid and the outer edge of the positioning part of the case. Here, since the conductor and the magnetic sensor are positioned in the case and the lid magnetic shield is positioned in the lid, the conductor, the magnetic sensor, and the lid magnetic shield can be positioned with high accuracy, an influence from a magnetic field of an adjacent conductor can be minimized, and the magnetic field of the conductor that is an object to be detected can be detected with high accuracy.

Preferably, in the current sensor according to the aspect of the invention, the case is made of resin, and the conductor is fixed by integral molding.

According to this configuration, the conductor is fixed to the case by integral molding. Therefore, the conductor and the case can be positioned with high accuracy.

Additionally, according to this configuration, the case includes the first opening through which the magnetic sensor is capable of being inserted into the housing space. Therefore, the magnetic sensor can be inserted into the case after the conductor and the case are integrally molded.

Preferably, in the current sensor according to the aspect of the invention, the lid magnetic shield is fixed to the lid by integral molding.

According to this configuration, the lid magnetic shield is assembled into the lid by integral molding. Therefore, the lid magnetic shield and the lid can be positioned with high accuracy.

Preferably, the current sensor according to the aspect of the invention further include a case magnetic shield fixed to the case by integral molding on a side of the lid opposite to the conductor.

According to this configuration, the magnetic field of the conductor that is an object to be detected can be detected with high accuracy by minimizing an influence from an external magnetic field which becomes noise from a side of the conductor opposite to the lid.

Preferably, in the current sensor according to the aspect of the invention, the conductor includes, within the case, at least one bent part, a first conductor located on one side of the bent part, and a second conductor located on the other side of the bent part, and the positioning part of the case includes a first restricting part configured to restrict movement of the first conductor in a first movement direction, and a second restricting part configured to restrict movement of the second conductor in a second movement direction.

According to this configuration, the direction of the conductor can be changed, the movement of the conductor in the first movement direction and the second movement direction can be restricted, and positioning of the conductor can be made easy.

Preferably, in the current sensor according to the aspect of the invention, the second opening of the lid has a configuration in which a terminal electrode of one end of the conductor is exposed to the outside of the case, and the case includes a third opening for locating a side of the conductor opposite to the one end outside of the case.

According to this configuration, the housing space formed by the lid and the case and outside thereof can be made to communicate with each other in two places, and one end of the conductor and its opposite side can be located outside of the housing space.

Preferably, in the current sensor according to the aspect of the invention, the positioning part includes a fourth opening in which a conductive tubular nut engaged with one end of the conductor is housed and fixed.

According to this configuration, the conductive tubular nut constitutes a portion of the electrode together with one end of the conductor, and an electrical resistance of a junction part can be made small by increasing the contact area between the one end of the conductor and its mating terminal.

Preferably, the current sensor according to the aspect of the invention further includes a plurality of the conductors, a plurality of the magnetic sensors that are provided corresponding to respective currents to be measured and are configured to measure induction fields that the currents to be measured generate, and a circuit board on which the plurality of magnetic sensors are mounted, and the first opening has a shape through which the circuit board into the housing space is capable of being inserted.

According to this configuration, the invention can be applied to multiphase conductors.

Preferably, in the current sensor according to the aspect of the invention, the outer edge of the second opening of the lid and the positioning part of the case have a recessed polygonal shape in a plan view as seen from a direction orthogonal to the lid, and the positioning part is fitted into the second opening.

According to this configuration, it can be made difficult for the lid to move with respect to the case and relative positional accuracy of both of the lid and case can be enhanced.

Preferably, in the current sensor according to the aspect of the invention, the internal angles of the plurality of vertices of the recessed polygonal shape are about 90 degrees or about 270 degrees.

According to this configuration, since bases become narrower than tips if the interior angles of the plurality of vertices of the above recessed polygonal shape are smaller than 90 degrees or greater than 270 degrees, damage easily occurs. If the internal angles are 90 degrees or 270 degrees, positional accuracy can be enhanced, and it can be made difficult for damage to occur.

Preferably, in the current sensor according to the aspect of the invention, the positioning part engages with the lid, and has a stepped part including a height difference in a direction orthogonal to a planar direction in which movement of the lid is restricted in the planar direction of the lid.

According to this configuration, the stepped part in the thickness direction of the lid also can further minimize the movement of the lid in the planar direction and allows for positioning with high accuracy.

According to the invention, a current sensor that can perform positioning between the conductor, the magnetic sensor, and the magnetic shield with high accuracy and can measure the current to be measured with high accuracy can be provided.

### BRIEF DESCRIPTION OF THE DRAWINGS

FIG. 1 is an external perspective view of a current sensor of an embodiment of the invention.
FIG. 2 is an exploded perspective view as seen from a lid side of the current sensor illustrated in FIG. 1.
FIG. 3 is an exploded perspective view as seen from a case side of the current sensor illustrated in FIG. 1.
FIG. 4 is a front view when the lid illustrated in FIG. 1 is seen from a Z2 direction.
FIG. 5 is a bottom view when the lid molded integrally with a lid magnetic shield is seen from a Z1 direction.
FIG. 6 is a side view when the lid molded integrally with the lid magnetic shield is seen from an X2 direction.
FIG. 7 is a perspective view when the lid molded integrally with a lid magnetic shield 21 is seen from an oblique direction on a bottom surface side.
FIG. 8 is a front view when the current sensor of the embodiment of the invention is seen from the Z2 direction.
FIG. 9 is an external perspective view of the case of the current sensor illustrated in FIG. 1.
FIG. 10 is a view for explaining the shape of an electrode housing part of a positioning part illustrated in FIG. 1.
FIG. 11 is a sectional view of the current sensor in sectional line A-A illustrated in FIG. 1.
FIG. 12 is an external perspective view of a conductor of the current sensor illustrated in FIG. 1.
FIG. 13 is a view for explaining a positional relationship among a first terminal electrode, the lid magnetic shield, and the electrode housing part.
FIG. 14 is an external perspective view of the current sensor in a state where the lid and the lid magnetic shields are removed.
FIG. 15 is a view for explaining the first terminal electrode of the embodiment of the invention.

### DESCRIPTION OF THE PREFERRED EMBODIMENTS

Hereinafter, a current sensor of an embodiment of the invention will be described.

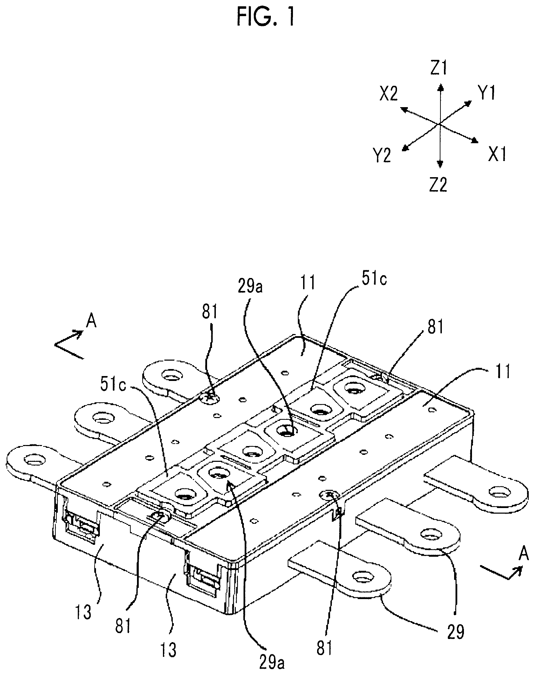

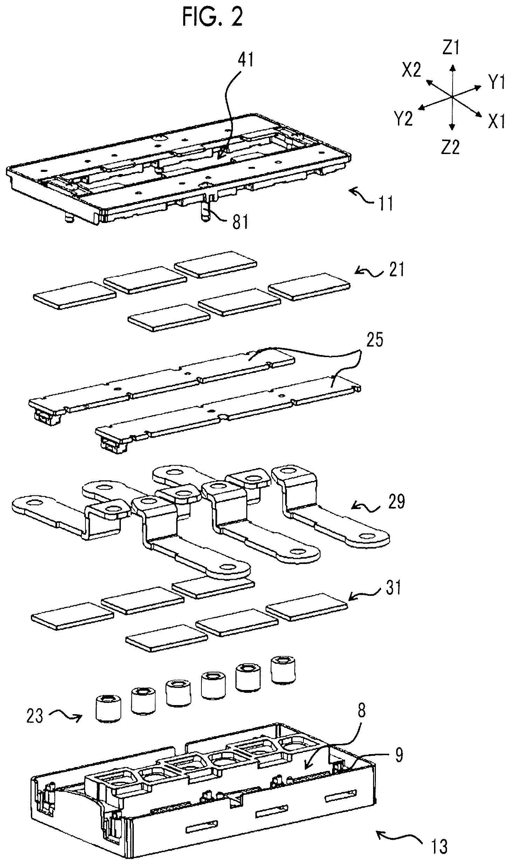

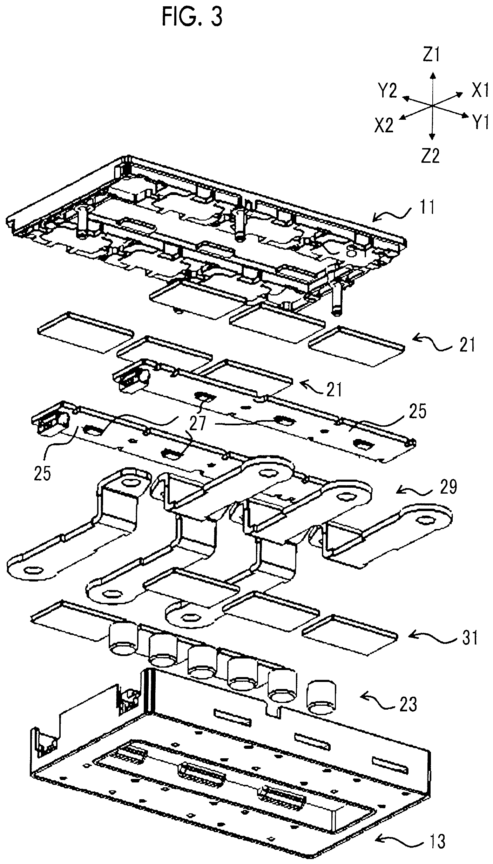

FIG. 1 is an external perspective view of a current sensor 1 of the embodiment of the invention, FIG. 2 is an exploded perspective view as seen from a lid 11 side of the current sensor 1 illustrated in FIG. 1, and FIG. 3 is an exploded perspective view as seen from a case 13 side of the current sensor 1 illustrated in FIG. 1.

As illustrated in FIGS. 1 to 3, in the present embodiment, a lateral direction of the lid 11 is defined as an X1-X2 direction, a longitudinal direction of the lid 11 is defined as a Y1-Y2 direction, and a direction orthogonal to the surface of the lid 11 is defined as a Z1-Z2 direction.

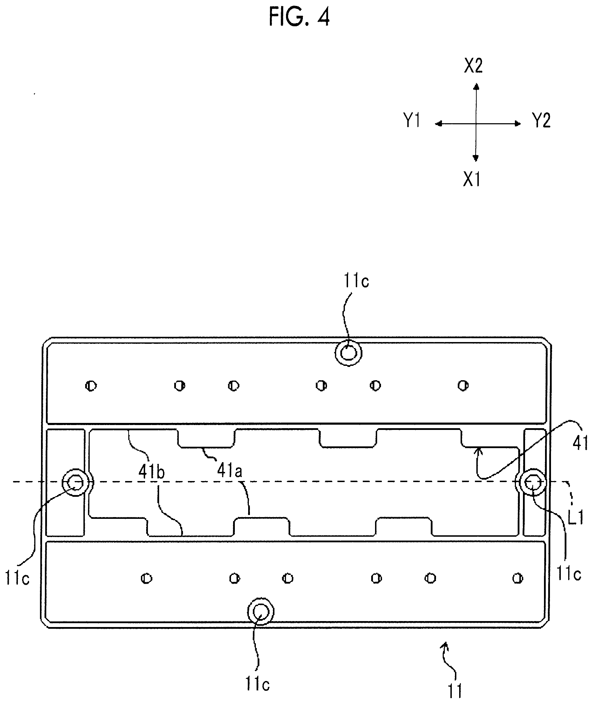

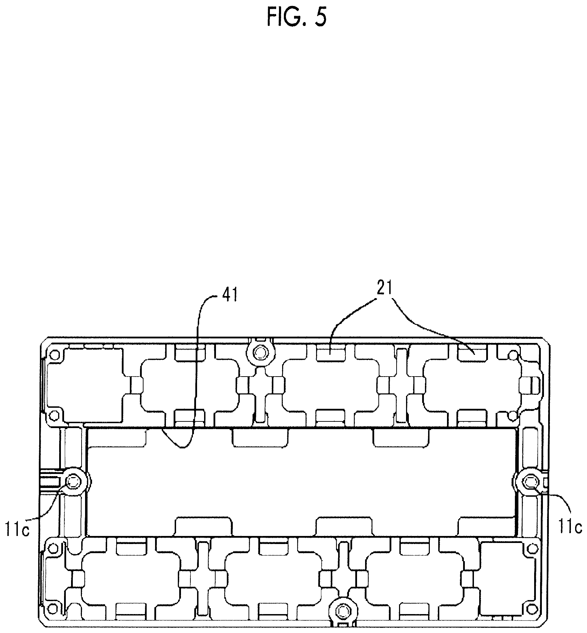

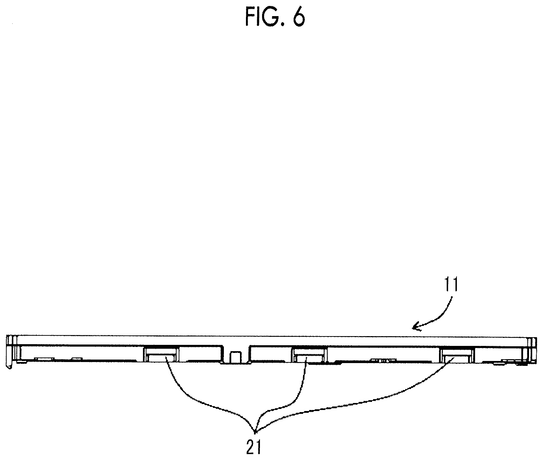

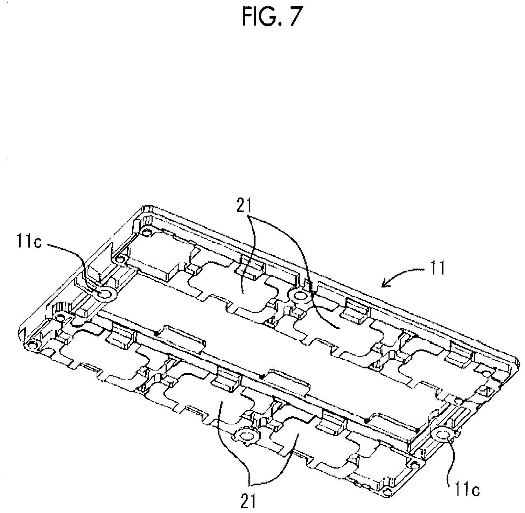

FIG. 4 is a front view when the lid 11 is seen from a Z2 direction, FIG. 5 is a bottom view when the lid 11 molded integrally with a lid magnetic shield 21 is seen from the Z1 direction, FIG. 6 is a side view when the lid 11 molded integrally with the lid magnetic shield 21 is seen from a X2 direction, and FIG. 7 is a perspective view when the lid 11 molded integrally with the lid magnetic shield 21 is seen from an oblique direction on a bottom surface side.

As illustrated in FIGS. 1 to 3, the current sensor 1 has, for example the lid 11, the case 13, the lid magnetic shield 21, a conductive nut 23, a circuit board 25, a magnetic sensor 27, a conductor (current path) 29, and a case magnetic shield 31.

The current sensor 1 has the conductor 29 through which a current to be measured flows, the magnetic sensor 27 that measures an induction field that the current to be measured generates, the case 13 that houses the conductor 29 and the magnetic sensor 27 in a state where the conductor 29 and the magnetic sensor 27 are positioned and that includes a first opening 9 that allows the magnetic sensor 27 to be inserted into a housing space 8 therethrough, the insulating lid 11 that covers the first opening 9 of the case 13 and includes a second opening 41 for allowing the conductor 29 to communicate with the outside of the case 13, and the lid magnetic shield 21 that is positioned in the lid 11.

Here, the case 13 has a positioning part 51 including an outer edge 51a that is engaged with the second opening 41 of the lid 11 and is positioned.

In the current sensor 1, the lid 11 and the case 13 are positioned with high accuracy with a simple configuration by the engagement between the second opening 41 of the lid 11 and the outer edge 51a of the positioning part 51 of the case 13. Here, since the conductor 29 and the magnetic sensor 27 are positioned in the case 13 and the lid magnetic shield 21 is positioned in the lid 11, the conductor 29, the magnetic sensor 27, and the lid magnetic shield 21 can be positioned with high accuracy, influence from a magnetic field of an adjacent conductor can be minimized, and the magnetic field of the conductor 29 that is an object to be detected can be detected with high accuracy.

As illustrated in FIGS. 1 to 3, the case 13 has the housing space 8 that houses portions of the circuit board 25, the magnetic sensor 27, and the conductor 29.

The circuit board 25 and the magnetic sensor 27 are inserted into the housing space 8 of the case 13 and are positioned and fixed via the first opening 9.

Hereinafter, the configuration of the current sensor 1 will be described in detail.

As illustrated in FIGS. 3, 5, 6, and 7, six lid magnetic shields 21 are assembled into the lid 11 by integral molding so as to be exposed to a bottom surface side of the lid. Each lid magnetic shield 21 has magnetic permeability higher than air.

The second opening 41 for allowing the first terminal electrode 29a of the conductor 29 to communicate with the outside therethrough is formed at the center of the lid 11.

As will be described below, the second opening 41 has a function of being engaged with the outer edge 51a of the positioning part 51 of the case 13 and positioning the lid 11 and the case 13 with high accuracy.

Three lid magnetic shields 21 are respectively assembled in the Y1-Y2 direction into both sides of the second opening 41 in the X1-X2 direction. The lid 11 is constituted of an insulating member.

As described above, since each lid magnetic shield 21 is molded integrally with the lid 11 at the time of molding of the lid 11, the lid magnetic shield is positioned with high accuracy at predetermined positions of the lid 11.

As illustrated in FIG. 1, six positioning parts 51 of the case 13 are linearly located at equal intervals in the second opening 41 of the lid 11, and an end surface 51c of each positioning part 51 is exposed to the outside.

As illustrated in FIGS. 4 to 7, the second opening 41 has a recessed polygonal shape in a plan view as seen from a Z1-Z2 direction orthogonal to the lid 11.

The second opening 41 has a plurality of protrusions 41a and recesses 41b in the X1-X2 direction on respective sides in the X1-X2 direction with respect to a central axis L1 in the Y1-Y2 direction.

The positions of each protrusion 41a and each recess 41b in the Y1-Y2 direction are different from each other on X1 and X2 sides.

As illustrated in FIG. 4, the internal angles of the plurality of vertices of the above recessed polygonal shape of the lid 11 are about 90 degrees or about 270 degrees.

Since bases become narrower than tips if the internal angles of the plurality of vertices of the above recessed polygonal shape are smaller than 90 degrees or greater than 270 degrees, damage easily occurs. As described above, if the internal angles of the vertices of the recessed polygonal shape of the lid 11 are 90 degrees or 270 degrees, positional accuracy can be enhanced, and damage can be made it difficult to occur.

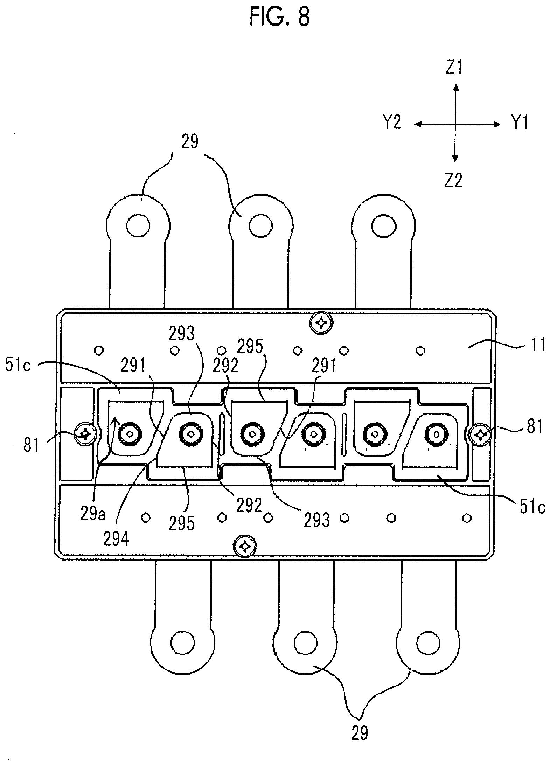

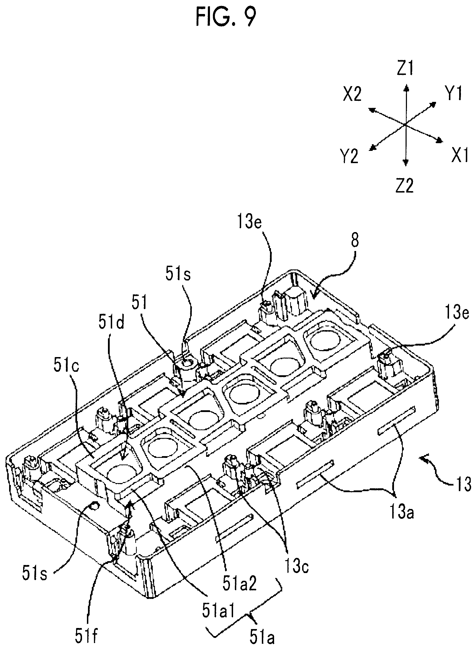

FIG. 8 is a front view when the current sensor 1 is seen from the Z2 direction. FIG. 9 is an external perspective view of the case 13 of the current sensor 1.

As illustrated in FIGS. 8 and 9, each positioning part 51 protrudes toward the lid 11 from a bottom surface of the case 13. The case 13 is formed of, for example, an insulating member, such as resin.

The outer edge 51a of the positioning part 51 of the case 13 on the lid 11 side has the same recessed polygonal shape as the second opening 41, and is fitted into the second opening 41.

The outer edge 51a has a recess 51a1 that fits to a protrusion 41a of the second opening 41 illustrated in FIG. 4, and a protrusion 51a2 that fits to a recess 41b.

The lid 11 may be easily attached to the case 13 by providing a minute gap to such a degree that that measurement accuracy (for example, 0.1 mm or less, though based on various dimensions or the like) is not affected, between the second opening 41 of the lid 11 and the outer edge 51a of the positioning part 51.

As illustrated in FIG. 1, the end surface 51c of the outer edge 51a on the Z1 side protrudes in the Z1 direction compared to a surface 11a of the lid 11 on the Z1 side. It is not necessary that the end surface 51c higher than an upper surface of the lid 11.

The six positioning parts 51 are linearly locate in the Y1-Y2 direction. Each positioning part 51 has a concave electrode housing part 51d that fixes and houses the first terminal electrode 29a of the conductor 29. Although six phases are illustrated in the present example, the number of phases is arbitrary.

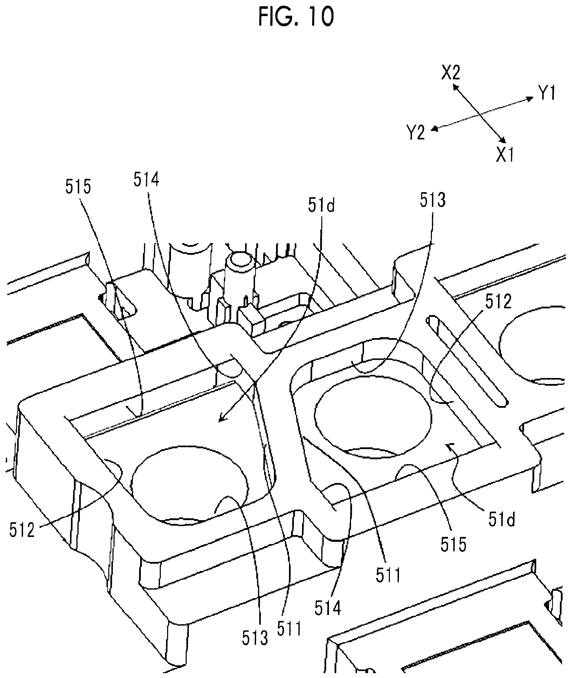

FIG. 10 is a view for explaining the shape of the electrode housing part 51d of each positioning part 51 illustrated in FIG. 1.

The electrode housing part 51d, in a plan view as seen from the Z2 direction, has a first side 511 that forms a predetermined angle with respect to the Y1-Y2 direction, and a second side 512 that extends in the X1-X2 direction.

The first side 511 is parallel to the first side 511 of a positioning part 51 adjacent thereto on one side.

The second side 512 of the electrode housing part 51d is parallel to the second side 512 of a positioning part 51 adjacent thereto on the other side.

The electrode housing part 51d has one end serving as the first side 511 and the other end serving as one end of the second side 512, and has a third side 513 that extends in the Y1-Y2 direction.

Distances between the first side 511, the second side 512, and the third side 513, and the center of a fourth opening 23a of a conductive cylindrical nut 23 are equal to each other.

The electrode housing part 51d has one end serving as the other end of the first side 511, and has a parallel fourth side 514 that extends in the X1-X2 direction.

The electrode housing part 51d has a fifth side 515 that connects the other end of the fourth side 514 and the other end 512 of the second side together, and extends in the Y1-Y2 direction.

A first terminal electrode 29a of the conductor 29 is located in the electrode housing part 51d so as to become flush with a Z1 surface side.

The case 13, as illustrated in FIG. 1, is molded integrally with the conductor 29 such that the first terminal electrode 29a is housed in the electrode housing part 51d. The conductor 29 is molded integrally with the case 13. Therefore, the case 13 and the conductor 29 are positioned with high accuracy.

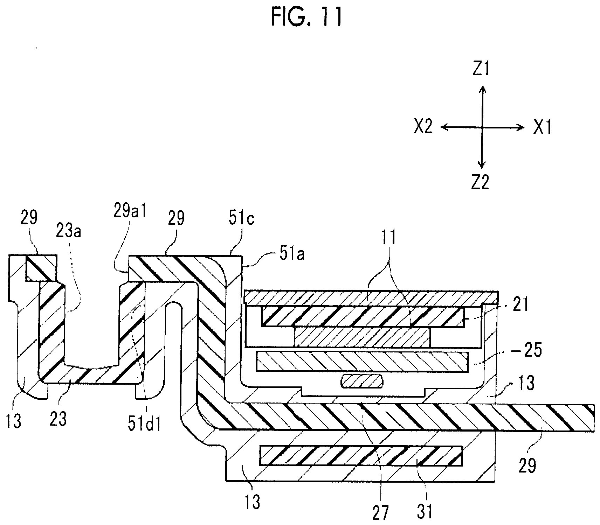

FIG. 11 is a sectional view of the current sensor 1 in sectional line A-A illustrated in FIG. 1.

As illustrated in FIG. 11, the case magnetic shield 31 is assembled into the case 13 by integral molding. Therefore, positioning between the case 13 and the case magnetic shield 31 is performed with high accuracy. Additionally, downsizing of the case 13 also becomes possible.

As illustrated in FIG. 9, in order to locate portions of six conductors 29 opposite to first terminal electrodes 29a thereof outside of the case 13, six third openings 13a that communicate with the first terminal electrodes 29a are formed at positions corresponding to electrode housing parts 51d of two facing lateral surfaces of the case 13.

Each positioning part 51 is engaged with the lid 11, and has a stepped part 51f including a height difference in a direction (Z direction) orthogonal to a planar direction in which movement of the lid 11 is restricted in the planar direction (X-Y) of the lid 11. By providing the stepped part 51f, the positional accuracy in a height direction (Z1-Z2 direction) between the lid 11 and the case 13 can be enhanced.

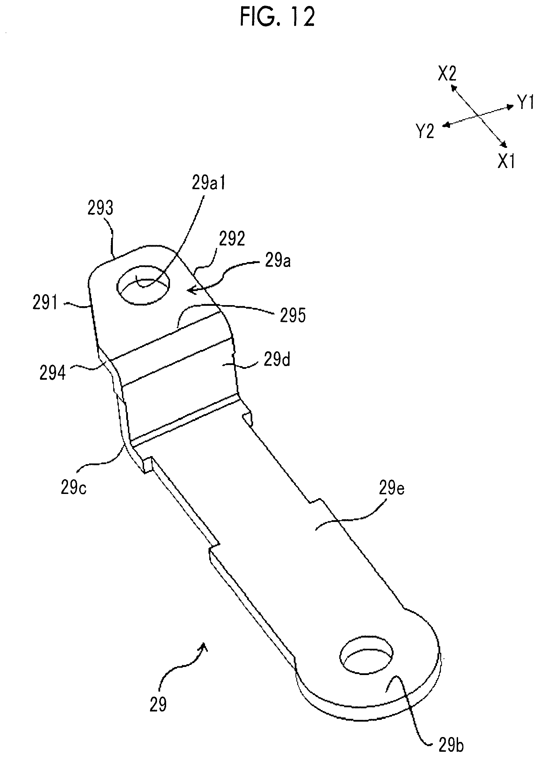

FIG. 12 is an external perspective view of a conductor 29.

As illustrated in FIG. 12, the conductor 29 has the first terminal electrode 29a at one end, and has a second terminal electrode 29b at the other end.

The conductor 29 has a bent part 29c. The first terminal electrode 29a side serves as a first conductor 29d with respect to the bent part 29c of the conductor 29, and the second terminal electrode 29b side serves as a second conductor 29e with respect to the bent part 29c.

The first conductor 29d extends in the Z1-Z2 direction, and the second conductor 29e extends in the X1-X2 direction.

Additionally, a hole 29a1 is formed at the center of the first terminal electrode 29a.

The first terminal electrode 29a of the conductor 29, in the plan view as seen from the Z2 direction, has a first side 291 that forms a predetermined angle with respect to the Y1-Y2 direction, and a second side 292 that extends in the X1-X2 direction.

The first side 291 is parallel to the first side 291 of a conductor 29 adjacent thereto on one side.

The second side 292 of the first terminal electrode 29a is parallel to the second side 292 of a conductor 29 adjacent thereto on the other side.

The first terminal electrode 29a has one end serving as the first side 291 and the other end serving as one end of the second side 292, and has a third side 293 that extends in the Y1-Y2 direction.

Distances between the first side 291, the second side 292 and the third side 293, and the center of the conductive cylindrical nut 23 are equal to each other.

The first terminal electrode 29a has one end serving as the other end of the first side 291, and has a parallel fourth side 294 that extends in the X1-X2 direction.

The first terminal electrode 29a has a fifth side 295 that connects the other end of the fourth side 294 and the other end 292 of the second side together, and extends in the Y1-Y2 direction.

The first side 291, the second side 292, the third side 293, the fourth side 294, and the fifth side 295 of the first terminal electrode 29a face and engage with the first side 511, the second side 512, the third side 513, the fourth side 514, and the fifth side 515 of the electrode housing part 51d.

When the conductor 29 is assembled into the case 13 by integral molding, the first terminal electrode 29a is fixed within the electrode housing part 51d.

Although a lead-out wiring line is fixed to the first terminal electrode 29a, it is preferable that the lead-out wiring lines of respective phases are wired so as to be located on corresponding phases. Accordingly, influence resulting from electric currents of adjacent phases can be made small.

In the present embodiment, as illustrated in FIG. 8 or the like, a distance in the Y1-Y2 direction can be shortened compared to a case where a side-by-side arrangement is adopted by forming the first terminal electrode 29a of the conductor 29 not into a tapered shape but into a rectangular shape. Therefore, downsizing of the current sensor 1 becomes possible without worsening the influence of an external magnetic field, and in the case of the same size, the intervals of the electrodes can be lengthened.

The first conductor 29d, as illustrated in FIG. 11, is restricted in movement in the X1-X2 direction by a first restricting part 13b of the case 13.

Additionally, the second conductor 29e is restricted in movement in the Z1-Z2 direction by a second restricting part 13c of the case 13.

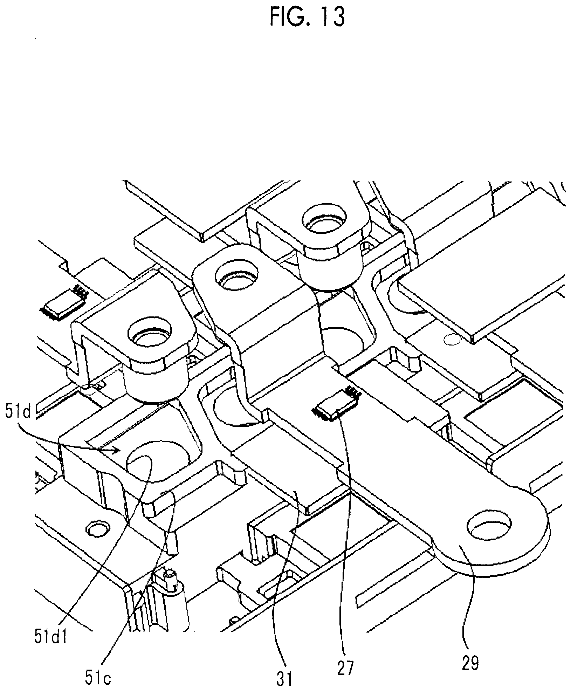

As illustrated in FIG. 12, the first terminal electrode 29a has the hole 29a1 in the vicinity of the center thereof. Additionally, as illustrated in FIGS. 10 and 13, a hole 51dl is formed in a bottom surface of a recess of the electrode housing part 51d.

As illustrated in FIGS. 11 and 13, the hole 51d1 abuts against the conductive cylindrical nut 23. Here, the central axes of the hole 51d1 and the nut 23 coincide with each other.

The central axes of the holes 29a1 of the first terminal electrodes 29a of the six conductors 29 that are linearly located and the central axles of the six nuts 23 that are linearly located coincide with each other, respectively.

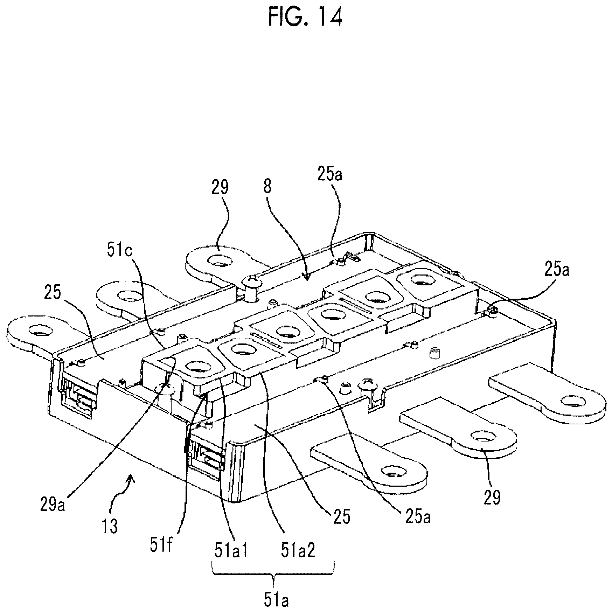

FIG. 14 is an external perspective view of the current sensor 1 in a state where the lid 11 and the lid magnetic shields 21 are removed.

As illustrated in FIGS. 9 and 14, the circuit board 25 is positioned and fixed to a plurality of fixing parts 13e of the case 13 by bosses 25a.

A magnetic sensor 27 is fixed to a position corresponding to each conductor 29 on the conductor 29 side of the circuit board 25. In addition, as the magnetic sensor 27, for example, a magneto-resistive effect element, a hall element, or the like can be used.

As illustrated in FIGS. 2 and 11, on the bottom surface side of the case 13, the case magnetic shields 31 are respectively fixed to positions corresponding to the six conductors 29 by integral molding.

As illustrated in FIG. 1, a screw 81 is passed through each hole 11c illustrated in FIG. 4, and is fixed to each fixing part 13e of the case 13. Accordingly, the lid 11 is fixed to the case 13.

The current sensor 1 is manufactured by the following manufacturing process.

Each lid magnetic shield 21 and the lid 11 are integrally molded by injection molding or the like. Accordingly, the lid magnetic shield 21 is positioned with high accuracy in the lid 11.

Additionally, each conductor 29, each case magnetic shield 31, and the case 13 are integrally molded by injection molding. Additionally, in this case, as illustrated in FIG. 13, each nut 23 is molded integrally with the case 13 so as to bring about a state where the first terminal electrode 29a of the conductor 29 is electrically connected to the electrode housing part 51d of the positioning part 51 of the case 13.

Accordingly, each conductor 29, each case magnetic shield 31, the case 13, and each nut 23 are positioned with high accuracy.

Next, as illustrated in FIG. 14, the circuit board 25 to which the magnetic sensor 27 is fixed is fixed to the fixing part 13e of the case 13 by each boss 25a. Accordingly, the circuit board 25 is positioned with high accuracy in the case 13.

Next, the second opening 41 of the lid 11 and the outer edge 51a of the electrode housing part 51d of the positioning part 51 of the case 13 are positioned, and the second opening 41 is fitted into the electrode housing part 51d. Then, as illustrated in FIG. 1, the screw 81 is passed through the hole 11c illustrated in FIG. 4, and is fixed to the fixing part 13e of the case 13. Accordingly, the lid 11 is positioned and fixed to the case 13.

As described above, according to the current sensor 1, the lid 11 and the case 13 are positioned with high accuracy with a simple configuration by the fitting (engagement) between the second opening 41 of the lid 11 and the positioning part 51 of the case 13. Here, since the conductors 29, the circuit board 25, and the magnetic sensors 27 are positioned in the case 13 and the lid magnetic shield 21 are positioned in the lid 11, the conductor 29, the magnetic sensor 27, and the lid magnetic shield 21 can be positioned with high accuracy, influence from a magnetic field of an adjacent conductor can be minimized, and the magnetic field of the conductor 29 that is an object to be detected can be detected with high accuracy. Additionally, vibration can suppress degradation of properties resulting from shock or the like. Additionally, downsizing is possible.

Additionally, in the current sensor 1, the conductor 29 is fixed to the case 13 by integral molding. Therefore, the conductor 29 and the case 13 can be positioned with high accuracy.

Additionally, in the current sensor 1, the case 13 includes the first opening 9 that allows the circuit board 25, on which the magnetic sensor 27 is mounted, to be inserted into the housing space. Therefore, the circuit board 25 can be inserted into the case 13 after the conductor 29 and the case 13 are integrally molded.

Additionally, in the current sensor 1, the lid magnetic shield 21 is assembled into the lid 11 by integral molding. Therefore, the lid magnetic shield 21 and the lid 11 can be positioned with high accuracy.

Additionally, in the current sensor 1, the case magnetic shield 31 is fixed to the case 13 by integral molding. Therefore, the magnetic field of the conductor 29 can be detected with high accuracy by positioning the case magnetic shield 31 with high accuracy to suppress influence from an external magnetic field which becomes noise from the bottom part side of the case 13.

Additionally, as illustrated in FIG. 12, in the current sensor 1, the bent part 29c are provided. Accordingly, the direction of the conductor 29 can be changed. Additionally, as illustrated in FIG. 11, the movement of the conductor 29 in the X1-X2 direction is restricted by the first restricting part 13b of the case 13, and the movement of the conductor 29 in the Z1-Z2 direction can be restricted by the second restricting part 13c.

In the current sensor 1, the housing space formed by the lid 11 and the case 13 and its outside can be made to communicate with each other in two places (the second opening 41 and the third opening 13a), and one end of the conductor 29 and its opposite end can be located outside of the housing space.

In the current sensor 1, as described above, the central axis of the conductive tubular nut 23 and the central axis of the hole 29a1 of the first terminal electrode 29a of the conductor 29 coincide with each other, and both are in contact with each other. Therefore, the nut 23 constitutes a portion of the first terminal electrode 29a, and electrical resistance of a junction part can be made small by increasing the contact area between the first terminal electrode 29a and its mating terminal.

Additionally, since the plurality of the nuts 23 are linearly provided at equal intervals, positioning of the nuts 23 is easy, the manufacturing process can be made easy, and positioning accuracy can be enhanced.

Additionally, in the current sensor 1, the first terminal electrode 29a of the conductor 29 has the third side 293 in which one end serves as the first side 291 and the other end serves as one end of the second side 292. Also, the distances between the first side 291, the second side 292, and the third side 293, and the center of the fourth opening 23a of the nut 23 are equal to each other. Therefore, the center of the fourth opening 23a of the nut 23 can be located near the center of the hole 29a1 of the first terminal electrode 29a, and the electrical properties of the first terminal electrode 29a can be made excellent.

In the current sensor 1, as described above, by forming the second opening 41 of the lid 11 and the outer edge 51a of the positioning part 51 of the case 13 into a recessed polygonal shape and by fitting both of the second opening 41 and the outer edge 51a into each other in the X-Y direction, it can be made difficult for the lid 11 and the case 13 to move relatively, and positional accuracy of both of the lid 11 and the case 13 can be enhanced.

Meanwhile, since bases become narrower than tips if the internal angles of the plurality of vertices of the above recessed polygonal shape are smaller than 90 degrees or greater than 270 degrees, damage easily occurs. In the current sensor 1, by setting the internal angles of the recessed polygonal shape to 90 degrees or 270 degrees, positional accuracy can be enhanced, and damage can be made it difficult to occur.

In the current sensor 1, since the positioning part 51 has the stepped part 51f, the positional accuracy in the height direction (Z1-Z2 direction) between the lid 11 and the case 13 can be enhanced.

Additionally, in the current sensor 1, the first side 291 that forms a predetermined angles other than 90 degrees with respect to the Y1-Y2 direction (linear direction) illustrated in FIGS. 8 and 12, and the second side 292 substantially orthogonal to the linear direction are provided. Here, the first side 291 is parallel to the first side 291 of the first terminal electrode 29a adjacent thereto on one side in the linear direction. Therefore, it is possible to make the shapes of the plurality of first terminal electrodes 29a same as each other, and properties, such as electrical resistance, can be made uniform.

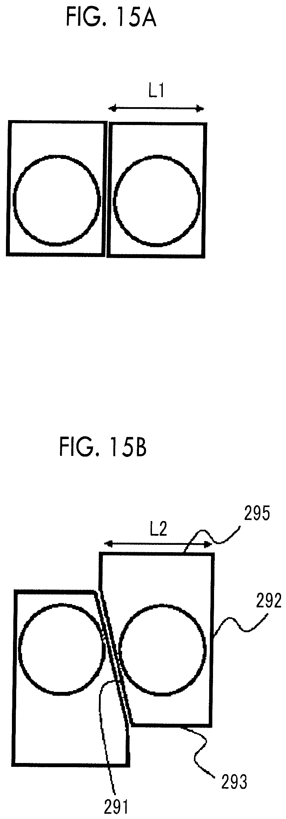

Additionally, in the current sensor 1, the first side 291 of the second side 292 of the first terminal electrode 29a is parallel to the second side 292 of the first terminal electrode 29a adjacent thereto on the other side. Therefore, since the adjacent conductors 29 overlap each other in the linear direction as compared to the width L1 (FIG. 15A) of each conductor in a case where the first side 291 is made to be orthogonal to the above linear direction. Therefore, the length L2 of the width (the fifth side 295) of the conductor 29 in the above linear direction can be lengthened by the same amount (FIG. 15B), and downsizing can be achieved while keeping electrical resistance low. That is, in FIG. 15A and FIG. 15B, L2 > L1 can be established. Additionally, it is possible to make the shapes of the plurality of first terminal electrodes 29a same as each other, and properties, such as electrical resistance, can be made uniform.

Additionally, the first terminal electrode 29a is formed by bending one end of the conductor 29 on the lid 11 side. Therefore, the first terminal electrode 29a can be formed in a simple process. Additionally, since the width of the conductor 29 is constant at the position (fifth side 295) where the conductor 29 is bent, bending accuracy can be enhanced.

Additionally, in the current sensor 1, the plurality of first terminal electrodes 29a are linearly provided. Therefore, according to the current sensor 1, positioning of each conductor 29 becomes easy, and the manufacturing process can be simplified.

Additionally, the first terminal electrode 29a of the current sensor 1 has one end serving as the other end of the first side 291, and has the fourth side 294 parallel to the second side 292, and the fifth side 295 that connects the other end of the fourth side 294 and the other end of the second side 292 together, is parallel to the third side 293, and is longer than the third side 293. Here, the fifth side 295 is located at a position distant from the center of the nut 23 compared to the third side 293. For this reason, the plurality of first terminal electrodes 29a can be efficiently arranged in a small region in the above linear direction.

Additionally, in the current sensor 1, the number of the first terminal electrodes 29a is six, that is, an even number. Therefore, both ends of the plurality of first terminal electrodes 29a that are arranged linearly can serve as the second side 292, can be made orthogonal to each other in the linear direction, and the space efficiency at which the first terminal electrodes 29a are arranged can be enhanced.

The invention is not limited to the above-described embodiment.

That is, a person skilled in the art may perform various changes, combinations, subcombinations, and substitutions with respect to the constituent elements of the above-described embodiment in the technical scope of the invention as defined in the appended claims. For example, in then above-described embodiment, the six-phase conductors are illustrated. However, the number of conductors is not limited. Additionally, in the above-described embodiment, as illustrated in FIG. 12, the conductor 29 having the bent part 29c is illustrated. However, the presence/absence of the bent part and the number of bent parts are not limited.

The invention relates to the current sensor used for measurement of an electric current that flow through a conductor.

It should be understood by those skilled in the art that various modifications, combinations, sub-combinations and alterations may occur depending on design requirements and other factors insofar as they are within the scope of the appended claims.

## Claims

1. A current sensor (1) comprising:
a conductor (29) through which a current to be measured flows;
a magnetic sensor (27) configured to measure an induction field that the current to be measured generates;
a case (13) configured to house the conductor (29) and the magnetic sensor (27) in a state where the conductor (29) and the magnetic sensor (27) are positioned and that includes a first opening (9) that allows the magnetic sensor (27) to be inserted into a housing space therethrough;
an insulating lid (11) configured to cover the first opening (9) of the case (13) and includes a second opening (41) for allowing the conductor (29) to communicate with the outside of the case (13); and
a lid magnetic shield (21) positioned in the lid (11),
wherein the case (13) includes a positioning part (51) including an outer edge (51a) that engages with the second opening (41) of the lid (11) to position the lid (11) on the case (13), and an end face (51c) of the positioning part (51) is exposed to the outside from the second opening (41).

2. The current sensor (1) according to Claim 1,
wherein the case (13) is made of resin, and the conductor (29) is fixed by integral molding.

3. The current sensor (1) according to Claim 1 or 2,
wherein the lid magnetic shield (21) is fixed to the lid (11) by integral molding.

4. The current sensor (1) according to any one of Claims 1 to 3, further comprising:
a case magnetic shield (31) fixed to the case (13) by integral molding on a side of the conductor (29) opposite to the lid (11).

5. The current sensor (1) according to any one of Claims 1 to 4,
wherein the conductor (29) includes, within the case (13), at least one bent part, a first conductor (29d) located on one side of the bent part, and a second conductor (29e) located on the other side of the bent part, and
wherein the positioning part (51) of the case (13) includes a first restricting part (13b) configured to restrict movement of the first conductor (29d) in a first movement direction, and a second restricting part (13c) configured to restrict movement of the second conductor (29e) in a second movement direction.

6. The current sensor (1) according to any one of Claims 1 to 5,
wherein the second opening (41) of the lid (11) has a configuration in which a terminal electrode (29a) of one end of the conductor (29) is exposed to the outside of the case (13), and
wherein the case (13) includes a third opening (13a) for locating a portion of the conductor (29) opposite to the one end outside of the case (13).

7. The current sensor (1) according to any one of Claims 1 to 6,
wherein the positioning part (51) includes a fourth opening (23a) in which a conductive tubular nut (23) engaged with one end of the conductor (29) is housed and fixed.

8. The current sensor (1) according to any one of Claims 1 to 7, further comprising:
a plurality of the conductors (29),
a plurality of the magnetic sensors (27) that are provided corresponding to respective currents to be measured and are configured to measure induction fields that the currents to be measured generate, and
a circuit board (25) on which the plurality of magnetic sensors (27) are mounted,
wherein the first opening (9) has a shape through which the circuit board (25) is capable of being inserted into the housing space.

9. The current sensor (1) according to any one of Claims 1 to 8,
wherein the outer edge of the second opening (41) of the lid (11) and the positioning part (51) of the case (13) have a recessed polygonal shape in a plan view as seen from a direction orthogonal to the lid (11), and
wherein the positioning part (51) is fitted into the second opening (41).

10. The current sensor (1) according to Claim 9,
wherein the internal angles of the plurality of vertices of the recessed polygonal shape are about 90 degrees or about 270 degrees.

11. The current sensor (1) according to any one of Claims 1 to 10,
wherein the positioning part (51) engages with the lid (11), and has a stepped part (51f) including a height difference in a direction orthogonal to a planar direction in which movement of the lid (11) is restricted in the planar direction of the lid (11).

## Patentansprüche

1. Stromsensor (1), aufweisend:
einen Leiter (29), durch den ein zu messender Strom fließt;
einen Magnetsensor (27), der zum Messen eines Induktionsfelds ausgebildet ist, das der zu messende Strom erzeugt;
ein Gehäuse (13), das zum Aufnehmen des Leiters (29) und des Magnetsensors (27) in einem Zustand ausgebildet ist, in dem der Leiter (29) und der Magnetsensor (27) positioniert sind, und das eine erste Öffnung (9) aufweist, die das Einführen des Magnetsensors (27) durch diese hindurch in einen Aufnahmeraum ermöglicht;
einen isolierenden Deckel (11), der zum Bedecken der ersten Öffnung (9) des Gehäuses (13) ausgebildet ist und eine zweite Öffnung (41) aufweist,
um dem Leiter (29) zu ermöglichen, mit der Außenseite des Gehäuses (13) zu kommunizieren; und
eine in dem Deckel (11) positionierte magnetische Deckelabschirmung (21),
wobei das Gehäuse (13) ein Positionierungsteil (51) mit einem äußeren Rand (51a) aufweist, der zur Positionierung des Deckels (11) an dem Gehäuse (13) mit der zweiten Öffnung (41) des Deckels (11) zusammenwirkt, und wobei eine Endfläche (51c) des Positionierungsteils (51) von der zweiten Öffnung (41) zur Außenseite freiliegt.

2. Stromsensor (1) nach Anspruch 1,
wobei das Gehäuse (13) aus Harz besteht und der Leiter (29) durch integrales Einformen festgelegt ist.

3. Stromsensor (1) nach Anspruch 1 oder 2,
wobei die magnetische Deckelabschirmung (21) durch integrales Einformen an dem Deckel (11) festgelegt ist.

4. Stromsensor (1) nach einem der Ansprüche 1 bis 3,
weiterhin aufweisend:
eine magnetische Gehäuseabschirmung (31), die an dem Gehäuse (13) durch integrales Einformen auf einer dem Deckel (11) entgegengesetzten Seite des Leiters (19) festgelegt ist.

5. Stromsensor (1) nach einem der Ansprüche 1 bis 4,
wobei der Leiter (29) innerhalb des Gehäuses (13) mindestens einen gebogenen Teil, einen ersten Leiter (29d), der sich auf der einen Seite des gebogenen Teils befindet, und einen zweiten Leiter (29e) aufweist, der sich auf der anderen Seite des gebogenen Teils befindet, und
wobei das Positionierungsteil (51) des Gehäuses (13) ein erstes Einschränkungsteil (13b) aufweist, das zum Einschränken der Bewegung des ersten Leiters (29d) in einer ersten Bewegungsrichtung ausgebildet ist, sowie ein zweites Einschränkungsteil (13c) aufweist, das zum Einschränken der Bewegung des zweiten Leiters (29e) in einer zweiten Bewegungsrichtung ausgebildet ist.

6. Stromsensor (1) nach einem der Ansprüche 1 bis 5,
wobei die zweite Öffnung (41) des Deckels (11) eine Konfiguration hat, bei der eine Anschlusselektrode (20a) des einen Endes des Leiters (29) zur Außenseite des Gehäuses (13) freiliegt, und
wobei das Gehäuse (13) eine dritte Öffnung (13a) zum Anordnen eines Bereichs des Leiters (29) gegenüber dem einen Ende außerhalb des Gehäuses (13) aufweist.

7. Stromsensor (1) nach einem der Ansprüche 1 bis 6,
wobei das Positionierungsteil (51) eine vierte Öffnung (23a) aufweist, in der eine leitfähige rohrförmige Mutter (23), die mit einem Ende des Leiters (29) zusammenwirkt, aufgenommen und befestigt ist.

8. Stromsensor (1) nach einem der Ansprüche 1 bis 7,
weiterhin aufweisend:
eine Mehrzahl der Leiter (29),
eine Mehrzahl der Magnetsensoren (27), die entsprechend den jeweiligen zu messenden Strömen vorhanden und zum Messen von Induktionsfeldern ausgebildet sind, die die zu messenden Ströme erzeugen, und
eine Leiterplatte (25), auf der die Mehrzahl der Magnetsensoren (27) angebracht ist,
wobei die erste Öffnung (9) eine Form aufweist, durch die die Leiterplatte (25) in den Aufnahmeraum eingeführt werden kann.

9. Stromsensor (1) nach einem der Ansprüche 1 bis 8,
wobei der äußere Rand der zweiten Öffnung (41) des Deckels (11) und das Positionierungsteil (51) des Gehäuses (13) in einer Draufsicht, gesehen aus einer Richtung orthogonal zu dem Deckel (11), eine vertiefte polygonale Form aufweisen, und
wobei das Positionierungsteil (51) in die zweite Öffnung (41) eingepasst ist.

10. Stromsensor (1) nach Anspruch 9,
wobei die Innenwinkel der Mehrzahl von Scheitelpunkten der vertieften polygonalen Form etwa 90 Grad oder etwa 270 Grad betragen.

11. Stromsensor (1) nach einem der Ansprüche 1 bis 10,
wobei das Positionierungsteil (51) mit dem Deckel (11) zusammenwirkt und einen abgestuften Teil (51f) aufweist, der einen Höhenunterschied in einer Richtung orthogonal zu einer Ebenenrichtung aufweist, in der die Bewegung des Deckels (11) in der Ebenenrichtung des Deckels (11) eingeschränkt ist.

## Revendications

1. Capteur de courant (1) comprenant :
un conducteur (29) par lequel passe un courant à mesurer ;
un capteur magnétique (27) configuré de manière à mesurer un champ d'induction que génère le courant à mesurer ;
un boîtier (13) configuré de manière à abriter le conducteur (29) et le capteur magnétique (27) dans un état où le conducteur (29) et le capteur magnétique (27) sont positionnés et qui comprend une première ouverture (9) permettant au capteur magnétique (27) d'être inséré dans un espace du boîtier à travers cette ouverture ;
un couvercle isolant (11) configuré de manière à couvrir la première ouverture (9) du boîtier (13) et qui comprend une deuxième ouverture (41) pour permettre au conducteur (29) de communiquer avec l'extérieur du boîtier (13) ; et
un blindage magnétique de couvercle (21) positionné dans le couvercle (11),
dans lequel le boîtier (13) comprend une pièce de positionnement (51) comportant un bord extérieur (51a) qui est en contact avec la deuxième ouverture (41) du couvercle (11) pour positionner le couvercle (11) sur le boîtier (13), et où une face d'extrémité (51c) de la pièce de positionnement (51) est exposée vers l'extérieur par rapport à la deuxième ouverture (41).

2. Le capteur de courant (1) selon la revendication 1,
dans lequel le boîtier (13) est constitué de résine et le conducteur (29) est fixé par moulage intégral.

3. Le capteur de courant (1) selon la revendication 1 ou 2,
dans lequel le blindage magnétique de couvercle (21) est fixé au couvercle (11) par moulage intégral.

4. Le capteur de courant (1) selon l'une quelconque des revendications 1 à 3, comprenant en outre :
un blindage magnétique de boîtier (31) fixé au boîtier (13) par moulage intégral sur un côté du conducteur (29) qui est à l'opposé du couvercle (11).

5. Le capteur de courant (1) selon l'une quelconque des revendications 1 à 4,
dans lequel le conducteur (29) comprend, dans le boîtier (13), au moins une pièce pliée, un premier conducteur (29d) situé sur un côté de la pièce pliée, et un deuxième conducteur (29e) situé sur l'autre côté de la pièce pliée, et
dans lequel la pièce de positionnement (51) du boîtier (13) comprend une première pièce de restriction (13b) configurée de manière à restreindre le mouvement du premier conducteur (29d) dans une première direction de mouvement, et une deuxième pièce de restriction (13c) configurée de manière à restreindre le mouvement du deuxième conducteur (29e) dans une deuxième direction de mouvement.

6. Le capteur de courant (1) selon l'une quelconque des revendications 1 à 5,
dans lequel la deuxième ouverture (41) du couvercle (11) présente une configuration dans laquelle une électrode terminale (29a) de l'une extrémité du conducteur (29) est exposée vers l'extérieur du boîtier (13), et
dans lequel le boîtier (13) comprend une troisième ouverture (13a) pour situer une partie du conducteur (29) à l'opposé de l'une extrémité à l'extérieur du boîtier (13).

7. Le capteur de courant (1) selon l'une quelconque des revendications 1 à 6,
dans lequel la pièce de positionnement (51) comprend une quatrième ouverture (23a) dans laquelle un manchon tubulaire conducteur (23) en contact avec une extrémité du conducteur (29) est logé et fixé.

8. Le capteur de courant (1) selon l'une quelconque des revendications 1 à 7, comprenant en outre :
une pluralité de conducteurs (29),
une pluralité de capteurs magnétiques (27) correspondant aux courants respectifs à mesurer et qui sont configurés de manière à mesurer des champs d'induction que les courants à mesurer génèrent, et
un circuit imprimé (25) sur lequel sont montés la pluralité de capteurs magnétiques (27),
dans lequel la première ouverture (9) présente une forme à travers laquelle le circuit imprimé (25) peut être inséré dans l'espace du boîtier.

9. Le capteur de courant (1) selon l'une quelconque des revendications 1 à 8,
dans lequel le bord extérieur de la deuxième ouverture (41) du couvercle (11) et la pièce de positionnement (51) du boîtier (13) ont une forme polygonale en creux selon une vue en plan, si l'on regarde depuis une direction orthogonale au couvercle (11) et
dans lequel la pièce de positionnement (51) est logée dans la deuxième ouverture (41).

10. Le capteur de courant (1) selon la revendication 9,
dans lequel les angles internes de la pluralité de sommets de la forme polygonale en creux sont à environ 90 degrés ou à environ 270 degrés.

11. Le capteur de courant (1) selon l'une quelconque des revendications 1 à 10,
dans lequel la pièce de positionnement (51) est en contact avec le couvercle (11) et présente une pièce étagée (51f) comprenant une différence de hauteur dans une direction orthogonale à un direction plane dans laquelle le mouvement du couvercle (11) est restreint dans la direction plane du couvercle (11).
